# EUROPEAN PATENT APPLICATION

(11) **EP 4 524 998 A1**
(43) Date of publication of application: **19.03.2025**
(21) Application number: 23803779.0
(22) Date of filing: 08.05.2023
(51) Int. Cl.: H01B 5/16, H01B 3/30, H01B 13/00, G03F 7/20, C08L 15/00

(54) **FLEXIBLE ANISOTROPIC CONDUCTIVE FILM INCLUDING CONDUCTIVE BALLS AND MANUFACTURING METHOD THEREFOR**

(30) Priority: 09.05.2022 KR 20220056785; 04.05.2023 KR 20230058551
(71) Applicant: Midas H&T Inc., Pohang-si Gyeongsangbuk-do 37673 (KR); Postech Academy-Industry Foundation, Gyeongsangbuk-do, 37673 (KR)
(72) Inventor: JEONG, Un Yong, Pohang-Si Gyeongsangbuk-do 37673 (KR); PARK, Doo Won, Pohang-Si Gyeongsangbuk-do 37673 (KR); CHANG, Se Yun, Gwacheon-si Gyeonggi-do 13818 (KR); PARK, Hye Ji, Pohang-si Gyeongsangbuk-do 37761 (KR)
(74) Representative: Carpmaels & Ransford LLP
(86) International application number: PCT/KR2023/006203
(87) International publication number: WO 2023/219356

(57) **Abstract**

The present invention relates to a flexible anisotropic conductive film including conductive balls and a manufacturing method therefor. The flexible anisotropic conductive film according to the present invention includes: a flexible base; and conductive balls which are inserted into and aligned in the flexible base.

## Description

### TECHNICAL FIELD

The present disclosure relates to a stretchable anisotropic conductive film (S-ACF) including conductive balls and a method of manufacturing the same.

### BACKGROUND ART

With recent advances in stretchable electrodes and device structures, stretchable electronic devices are evolving into high-resolution integrated circuits. When applying the electrical interface used in existing electronic devices as an interface between stretchable elements, problems such as peeling and cracking occur. To solve this problem, research on an anisotropic conductive film (ACF) that has electrical conductivity in a thickness direction is being conducted.

In order to form a stable interface between stretchable elements and prevent technical defects, an adhesive layer of ACF requires high toughness and stable adhesiveness, however an adhesive layer of an ACF of the related art does not have sufficient toughness or adhesiveness. In addition, since particles responsible for conductivity are irregularly arranged in the adhesive layer, it is difficult to form a high-resolution electrical interface between circuits with fine spacings and widths, and high pressure, temperature, and time are required to form a bond between elements. Therefore, there is a need to develop an ACF that has both excellent stretchability and conductivity to solve these problems.

The above description has been possessed or acquired by the inventor(s) in the course of conceiving the present disclosure and is not necessarily an art publicly known before the present application is filed.

### DISCLOSURE OF THE INVENTION

### TECHNICAL GOALS

To solve the above problems, the present disclosure provides a stretchable anisotropic conductive film (S-ACF) manufactured rapidly and simply at a low temperature under low pressure, and a method of manufacturing the same.

However, goals to be achieved are not limited to those described above, and other goals not mentioned above are clearly understood by one of ordinary skill in the art from the following description.

### TECHNICAL SOLUTIONS

A stretchable anisotropic conductive film (S-ACF) according to the present disclosure includes a S-ACF including: a stretchable base material; and conductive balls inserted and aligned within the stretchable base material.

According to an embodiment, the stretchable base material may include thermoplastic rubber grafted with maleic anhydride including at least one thermoplastic rubber selected from the group consisting of styrene-ethylene-butylene-styrene (SEBS), styrene-isoprene-styrene (SIS), styrene-butadiene-styrene (SBS), polyurethane (PU)-based rubber, and polyolefin (PO) rubber.

According to an embodiment, the conductive balls may include particles of at least one selected from the group consisting of polystyrene (PS), PU, polyethylene (PE), polypropylene (PP), polybutylene (PB), nylon, and styrene-divinyl benzene, and the particles may be coated with at least one selected from the group consisting of gold (Au), nickel (Ni), silver (Ag), copper (Cu), aluminum (Al), palladium (Pd), chromium (Cr), titanium (Ti), tin (Sn), and molybdenum (Mo).

According to an embodiment, the conductive ball may have a diameter of 1 micrometer (µm) to 100 µm, spacing between the conductive balls may be 1 µm to 100 µm, a pitch may be 2 µm to 200 µm, and the diameter of the conductive ball and the spacing between the conductive balls may have a ratio of 2:1 to 1:2.

According to an embodiment, the stretchable base material may have a thickness that is 40% to 70% of the diameter of the conductive ball.

According to an embodiment, the stretchable base material may have uniform physical properties over the entire portion, the conductive balls may be inserted and aligned vertically in a surface of the S-ACF so that both surfaces of the S-ACF are electrically connected, and the conductive ball may have 30% to 60% of an outer surface exposed to outside of the stretchable base material.

A method of manufacturing a S-ACF according to the present disclosure includes manufacturing a mold patterned with a pattern including a concave portion; disposing conductive balls in the mold; applying a stretchable base material onto the mold in which the conductive balls are disposed; and removing the mold.

According to an embodiment, the manufacturing of the mold may be performed by photolithography, nanoimprint, soft lithography, block copolymer lithography, or capillary lithography.

According to an embodiment, the manufacturing of the mold may include: preparing a ultraviolet (UV)-curable polymer; performing patterning by positioning a photomask on the UV-curable polymer and irradiating the photomask with UV light; and obtaining a patterned mold by washing the patterned UV-curable polymer, and the UV-curable polymer may include at least one selected from the group consisting of polyethylene glycol diacrylate (PEG-DA), epoxy acrylate, polyester acrylate, polyurethane arylate, and silicone acrylate.

According to an embodiment, in the performing of the patterning, the UV-curable polymer may be patterned into a cured hard gel and an uncured soft gel, the soft gel may form the concave portion, and the concave portion may have a depth that is 10% to 30% of a diameter of the conductive ball.

According to an embodiment, in the performing of the patterning, the UV light may be irradiated for 1 second to 10 seconds, a distance between the UV-curable polymer and a UV light source may be 8 cm to 16 cm, and the UV light may have intensity of 2 mW/cm² to 20 mW/cm².

According to an embodiment, in the disposing of the conductive balls, the conductive balls may be rubbed on the mold, the conductive ball may be adhered to the concave portion, and the concave portion may have an adhesive force of 1 nN to 90 nN.

According to an embodiment, the method may further include performing air blowing after the disposing of the conductive balls.

According to an embodiment, in the removing of the mold, the stretchable base material may be peeled off, and the conductive balls may be inserted and aligned in the stretchable base material.

### EFFECTS OF THE INVENTION

The present disclosure may provide a stretchable anisotropic conductive film (S-ACF) manufactured rapidly and simply at low temperature under low pressure, and a method of manufacturing the same.

Specifically, the method of manufacturing a S-ACF according to the present disclosure may provide a fast and simple method of manufacturing a S-ACF that does not require a hot press process with high temperature and pressure. In addition, particles may be arranged in various forms by setting a size and spacing of a desired pattern, and conductive balls with various sizes may be used to manufacture a S-ACF without a new mold design.

### BRIEF DESCRIPTION OF DRAWINGS

FIG. 1 is a schematic view of a stretchable anisotropic conductive film (S-ACF) according to an embodiment of the present disclosure.
FIG. 2 is a schematic view of a method of manufacturing a S-ACF according to an embodiment of the present disclosure.
FIG. 3 is a schematic view of a step of manufacturing a mold of a method of manufacturing a S-ACF according to an embodiment of the present disclosure.
FIG. 4 is a schematic view of a step of disposing conductive balls and a step of applying a stretchable base material of a method of manufacturing a S-ACF according to an embodiment of the present disclosure.
FIG. 5 is a scanning electron microscope (SEM) image of a patterned mold according to an embodiment of the present disclosure.
FIG. 6 is an optical microscope (OM) image (a) of a mold in which conductive balls are disposed and an SEM image (b) of a cross section of a S-ACF according to an embodiment of the present disclosure.
FIG. 7 is a graph showing a result of IV measurement of an electronic device to which a S-ACF is applied according to an embodiment of the present disclosure.

### BEST MODE FOR CARRYING OUT THE INVENTION

Hereinafter, embodiments will be described in detail with reference to the accompanying drawings. However, various alterations and modifications may be made to the embodiments. Here, the embodiments are not construed as limited to the disclosure. The embodiments should be understood to include all changes, equivalents, and replacements within the idea and the technical scope of the disclosure.

The terminology used herein is for the purpose of describing particular embodiments only and is not to be limiting of the embodiments. The singular forms "a", "an", and "the" are intended to include the plural forms as well, unless the context clearly indicates otherwise. It will be further understood that the terms "comprises/comprising" and/or "includes/including" when used herein, specify the presence of stated features, integers, steps, operations, elements, and/or components, but do not preclude the presence or addition of one or more other features, integers, steps, operations, elements, components and/or groups thereof.

Unless otherwise defined, all terms including technical and scientific terms used herein have the same meaning as commonly understood by one of ordinary skill in the art to which the embodiments belong. It will be further understood that terms, such as those defined in commonly-used dictionaries, should be interpreted as having a meaning that is consistent with their meaning in the context of the relevant art and will not be interpreted in an idealized or overly formal sense unless expressly so defined herein.

When describing the embodiments with reference to the accompanying drawings, like reference numerals refer to like components and a repeated description related thereto will be omitted. In the description of embodiments, detailed description of well-known related structures or functions will be omitted when it is deemed that such description will cause ambiguous interpretation of the present disclosure. In addition, the terms first, second, A, B, (a), and (b) may be used to describe constituent elements of the embodiments. These terms are used only for the purpose of discriminating one component from another component, and the nature, the sequences, or the orders of the components are not limited by the terms. It should be noted that if one component is described as being "connected," "coupled" or "joined" to another component, the former may be directly "connected," "coupled," and "joined" to the latter or "connected", "coupled", and "joined" to the latter via another component.

A component, which has the same common function as a component included in any one embodiment, will be described by using the same name in other embodiments. Unless disclosed to the contrary, the description of any one embodiment may be applied to other embodiments, and the specific description of the repeated configuration will be omitted.

Hereinafter, a stretchable anisotropic conductive film (S-ACF) and a method of manufacturing the same will be described in detail with reference to embodiments and drawings. However, the present disclosure is not limited to the embodiments and drawings.

A S-ACF according to the present disclosure includes a stretchable base material; and conductive balls inserted and aligned within the stretchable base material.

The S-ACF according to the present disclosure may change along with deformation of a substrate due to excellent stretchability, that is, flexibility, making it suitable for flexible electronic devices, may be applied to electronic devices to firmly bond an interface of different materials due to excellent adhesiveness, may maintain uniform and constant conductivity by including regularly arranged conductive balls, and may freely control an area where the conductive balls are arranged, thereby being used in various fields.

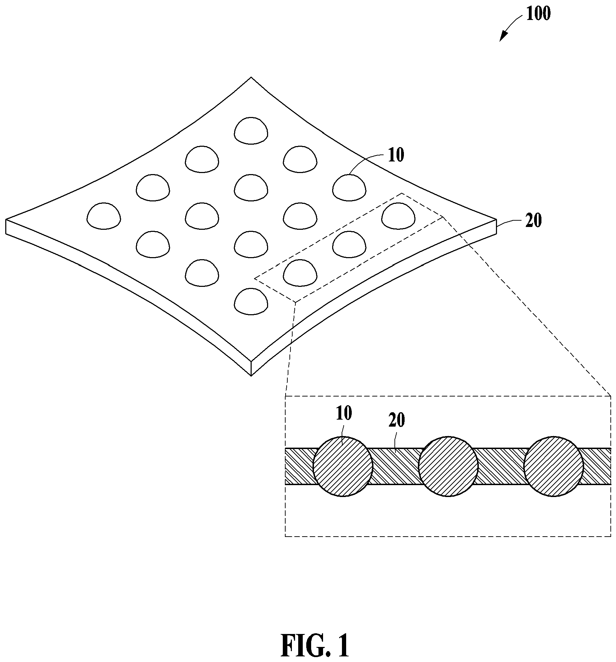

FIG. 1 is a schematic view of a S-ACF according to an embodiment of the present disclosure. Referring to FIG. 1, conductive balls 10 may be inserted and aligned within a stretchable base material 20, and a S-ACF 100 with a vertical conductive path in which a current flows vertically through a portion where the conductive balls 10 are exposed and a current is not able to flow horizontally due to the non-conductive stretchable base material 20 may be provided.

According to an embodiment, the stretchable base material may include thermoplastic rubber grafted with maleic anhydride including at least one thermoplastic rubber selected from the group consisting of styrene-ethylene-butylene-styrene (SEBS), styrene-isoprene-styrene (SIS), styrene-butadiene-styrene (SBS), polyurethane (PU)-based rubber, and polyolefin (PO) rubber.

The stretchable base material has excellent elasticity, high elongation, and low conductivity, thereby forming a S-ACF so that a current flows only at a desired area.

The thermoplastic rubber grafted with maleic anhydride has excellent flexibility and elasticity and may be suitable as a material for the stretchable base material. The thermoplastic rubber grafted with maleic anhydride may form a chemical bond with other materials such as a target substrate to form a stable bond even at low temperatures and low pressures. The thermoplastic rubber may be desirably SEBS, but is not limited those listed above.

The maleic anhydride may have a content of at least 1 wt% or more of the thermoplastic rubber. When the maleic anhydride is included in a content within the above range, it may have the effect of providing a sufficient number of bond formation sites with respect to a bonding area.

According to an embodiment, the conductive balls may include particles of at least one selected from the group consisting of polystyrene (PS), PU, polyethylene (PE), polypropylene (PP), polybutylene (PB), nylon, and styrene-divinyl benzene, and the particles are coated with at least one selected from the group consisting of gold (Au), nickel (Ni), silver (Ag), copper (Cu), aluminum (Al), palladium (Pd), chromium (Cr), titanium (Ti), tin (Sn), and molybdenum (Mo).

The conductive balls may form a S-ACF that has at least a conductive surface and is region-selectively conductive. The conductive balls are inserted into the stretchable base material and aligned therein. That is, the conductive balls may be in a form embedded in the stretchable base material and may be arranged and aligned in a regular manner.

The term "alignment" may refer to that a plurality of conductive balls are arranged at equal intervals or at intervals with a specific regularity. That is, when one conductive ball is inserted into the stretchable base material, another conductive ball may be positioned at a predetermined interval, and still another conductive ball may also be positioned at a predetermined interval from the other conductive ball. The conductive balls may be aligned in any one of a grid, honeycomb, linear, and square arrangement, but are not limited thereto and may be arranged in various forms as needed.

The conductive ball may be made entirely of metal particles or particles with a surface that is coated with a metal material, and shape thereof may be desirably spherical. Desirably, the conductive ball may have a core-shell structure including a core including an insulating polymer; and a shell including a metal. In a case of the core-shell structure, conductive balls with a uniform size may be utilized in the S-ACF, and a weight of the S-ACF may be reduced, thereby promoting weight reduction of a device and reducing production costs.

According to an embodiment, the conductive ball may have a diameter of 1 micrometer (µm) to 100 µm, spacing between the conductive balls may be 1 µm to 100 µm, a pitch may be 2 µm to 200 µm, and the diameter of the conductive ball and the spacing between the conductive balls may have a ratio of 2:1 to 1:2.

The diameter of the conductive ball may be desirably 1 µm to 80 µm; 1 µm to 60 µm; 1 µm to 40 µm; 1 µm to 20 µm; 2 µm to 80 µm; 2 µm to 60 µm; 2 µm to 40 µm; 2 µm to 20 µm; 5 µm to 80 µm; 5 µm to 60 µm; 5 µm to 40 µm; or 5 µm to 20 µm.

When the diameter of the conductive ball is less than 1 µm, the conductive ball may not be rolled but remain as it is when rubbing the conductive ball to arrange the conductive ball in the stretchable base material, which may cause a problem in forming a particle assembly. When the diameter of the conductive ball exceeds 100 µm, a problem regarding a resolution may occur.

Each individual conductive ball may have the same diameter. When the conductive balls with the same diameter are used, there may be no need for a separate bumper layer for anisotropic conduction since there is no step in a height direction of the S-ACF.

The spacing between the conductive balls may represent a closest distance between an end of one conductive ball and an end of another conductive ball. The spacing between the conductive balls may be desirably 1 µm to 80 µm; 1 µm to 60 µm; 1 µm to 40 µm; 1 µm to 20 µm; 2 µm to 80 µm; 2 µm to 60 µm; 2 µm to 40 µm; 2 µm to 20 µm; 5 µm to 80 µm; 5 µm to 60 µm; 5 µm to 40 µm; or 5 µm to 20 µm.

The pitch of the conductive balls may represent a distance between the center of one conductive ball to the center of another conductive ball. The pitch of the conductive balls may be desirably 2 µm to 160 µm; 2 µm to 120 µm; 2 µm to 80 µm; 2 µm to 40 µm; 4 µm to 160 µm; 4 µm to 120 µm; 4 µm to 80 µm; 4 µm to 40 µm; 10 µm to 160 µm; 10 µm to 120 µm; 10 µm to 80 µm; or 10 µm to 40 µm and a fine-pitch S-ACF may be provided.

When the spacing and the pitch of the conductive balls are less than the above range, there may be a problem in which the assembly is not formed properly. As the spacing between the conductive balls becomes narrower, contact phenomena such as electrostatic attraction between the conductive balls during the rubbing process may occur, causing cross-talk, and the conductive balls may be arranged densely, and thus, it may be difficult to arrange the conductive balls in a desired pattern. When the conductive balls are aligned with the spacing and the pitch within the above range, the performances such as conductivity and resolution may be constant throughout the entire area of the S-ACF due to the regular arrangement of particle diameter units, and thus, the precise design of the electrode interconnection may be possible. The spacing and the pitch of the conductive balls may be adjusted according to the arrangement, the diameter of the conductive ball, and the applied field of the S-ACF.

The diameter of the conductive ball and the spacing between the conductive balls may have a ratio of desirably 2:1 to 2:3; 2:1 to 1:1; 2:1 to 3:2; 3:2 to 1:1; 3:2 to 2:3; 3:2 to 1:2; 1:1 to 2:3; 1:1 to 1:2; or 2:3 to 1:2.

According to an embodiment, the stretchable base material may have a thickness that is 40% to 70% of the diameter of the conductive ball.

When the thickness of the stretchable base material is less than 40% of the diameter of the conductive ball, there may be a problem in which the conductive ball assembly is not properly formed or a problem in which a bond with a surface of an electrode substrate is not property formed due to a thin thickness of the stretchable base material. When the thickness of the stretchable base material exceeds 70%, the stretchable base material may cover the surfaces of the conductive balls, preventing the conductive ball from being exposed, which may cause a problem in conducting electricity.

When the thickness ratio of the stretchable base material is formed within the above range, a portion of the conductive ball is exposed from the surface of the stretchable base material, and high conductivity may be exhibited when the S-ACF is pressed with another member such as a target substrate.

The thickness of the stretchable base material may be 1 µm to 50 µm, but is not limited within the above range.

According to an embodiment, the stretchable base material may have uniform physical properties over the entire portion, the conductive balls may be inserted and aligned vertically in a surface of the S-ACF so that both surfaces of the S-ACF are electrically connected, and the conductive ball may have 30% to 60% of an outer surface exposed to outside of the stretchable base material.

A S-ACF of the related art contacted with another member such as a target substrate or the like with conductive balls exposed to the outside through hot press, thereby forming conductivity. The stretchable base material of the S-ACF that has undergone the hot press process may be in close contact with the conductive balls, and the conductive balls are exposed to outside and pushed. Accordingly, the physical properties may differ depending on the position and may not be uniform overall, and there may be a deformation in the stretchable base material before the hot press. Here, the physical properties may refer to elongation, toughness, and the like. On the other hand, the S-ACF according to the present disclosure is formed by applying the stretchable base material onto the conductive balls without the hot press process, and accordingly, the deformation of the stretchable base material does not occur. Therefore, the physical properties of the entire portion of the stretchable base material may be uniform regardless of the position of the conductive balls inserted into the stretchable base material.

The S-ACF may form a vertical conductive path through which a current flows through conductive balls inserted vertically. The conductive balls are exposed to the outside of upper and lower surfaces of the stretchable base material. When the conductive balls are exposed to the outside of the upper and lower surfaces of the stretchable base material, the current flowing from a member contacting one surface of the S-ACF may be caused to flow to another member contacting the other surface of the S-ACF.

The exposed outer surface may include both the upper and lower surfaces where the conductive balls are exposed. Desirably, the conductive ball may have 30% to 50%; 30% to 40%; 40% to 60%; 40% to 50%; or 50% to 60% of the outer surface that is exposed to the outside of the upper and lower surfaces of the stretchable base material. When the outer surface of the conductive ball is exposed within the above range, excellent conductivity may be secured with low connection resistance while minimizing the step of the S-ACF.

The S-ACF according to the present disclosure may have a stress of 10 MPa or less, 8 MPa or less, or 5 MPa or less when stretched at an elongation of 100%. When the S-ACF is stretched at an elongation of 100% and has a stress within the above range, the elasticity of the S-ACF may be excellent, and even when there is a physical stimulus, the conductivity does not decrease, and thus conductivity stability may be excellent. In addition, the S-ACF according to the present disclosure may have a stress of 10 MPa or less when stretched at an elongation of 200%.

A method of manufacturing a S-ACF according to the present disclosure includes manufacturing a mold patterned with a pattern including a concave portion; disposing conductive balls in the mold; applying a stretchable base material onto the mold in which the conductive balls are disposed; and removing the mold.

The method of manufacturing a S-ACF according to the present disclosure may provide a fine-pitch S-ACF having excellent elasticity and conductivity rapidly and simply at a low temperature under low pressure.

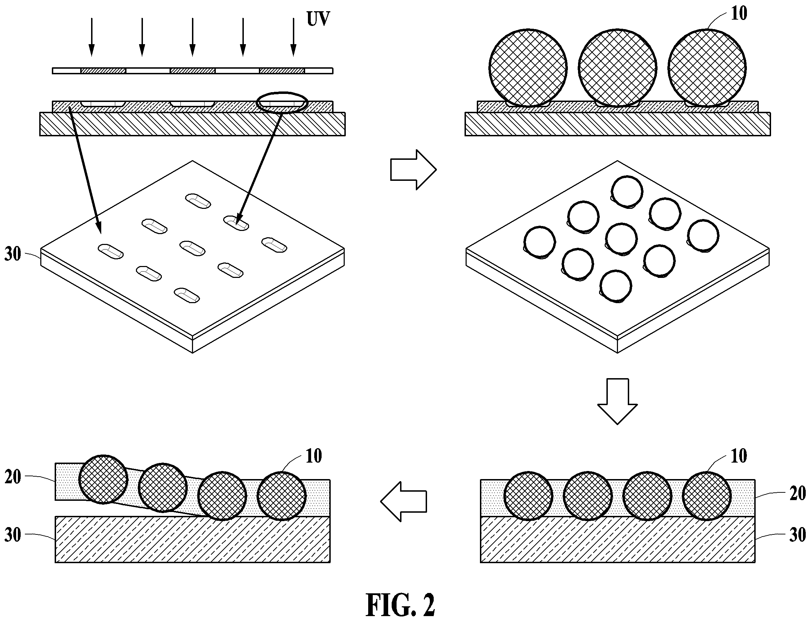

FIG. 2 is a schematic view of a method of manufacturing a S-ACF according to an embodiment of the present disclosure. Referring to FIG. 2, a mold 30 patterned with a pattern including a concave portion may be manufactured and the conductive balls 10 may be disposed on the patterned mold 30. The stretchable base material 20 may be applied onto the patterned mold 30 in which the conductive balls 10 are disposed, thereby obtaining the conductive balls 10 inserted into the stretchable base material 20. This may be peeled off to remove the patterned mold 30, thereby manufacturing the S-ACF.

While the method of manufacturing a S-ACF of the related art uses a method of performing the hot press, the method of manufacturing a S-ACF according to the present disclosure may use a method of applying the stretchable base material after disposing the conductive balls on the mold, to manufacture a fine-pitch S-ACF simply at a low temperature under low pressure.

Here, the characteristics of the conductive balls and the stretchable base material are the same as those described above, and therefore, the description thereof will be omitted.

In an embodiment, the manufacturing of the mold may be performed by photolithography, nanoimprint, soft lithography, block copolymer lithography, or capillary lithography.

The process by which the manufacturing of the mold is performed is not particularly limited, and the manufacturing of the mold may be desirably performed by the photolithography.

According to an embodiment, the manufacturing of the mold may include preparing a ultraviolet (UV)-curable polymer; performing patterning by positioning a photomask on the UV-curable polymer and irradiating the photomask with UV light; and obtaining a patterned mold by washing the patterned UV-curable polymer, and the UV-curable polymer may include at least one selected from the group consisting of polyethylene glycol diacrylate (PEG-DA), epoxy acrylate, polyester acrylate, polyurethane arylate, and silicone acrylate.

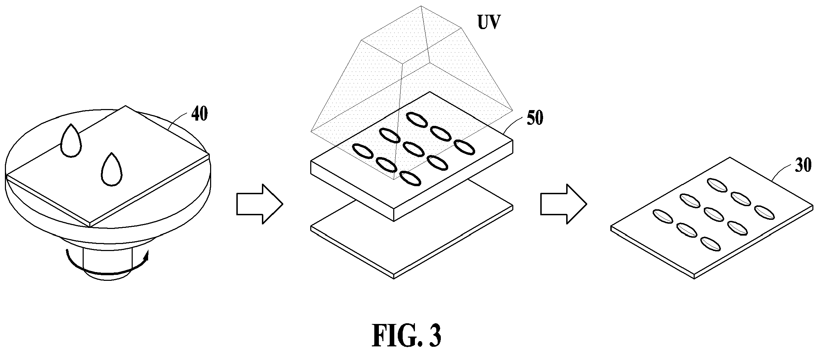

FIG. 3 is a schematic view of a step of manufacturing a mold of a method of manufacturing a S-ACF according to an embodiment of the present disclosure. Referring to FIG. 3, a UV-curable polymer 40 may be prepared by coating it, a photomask 50 may be positioned thereon, and then the photomask was irradiated with UV light to obtain the mold 30 patterned with a desired patterned.

In the preparing of the UV-curable polymer, the UV-curable polymer may be applied onto a wafer. The wafer is not particularly limited and may be selected from among a silicon wafer, glass, and a metal substrate. Desirably, the wafer may be a silicon wafer.

The wafer may be subjected to a chemical surface treatment to form a stable bond with the UV-curable polymer. When the photomask is peeled off from the UV-curable polymer by the chemical surface treatment, the UV-curable polymer may not be peeled off from the wafer. The surface treatment may be a treatment with a silane compound solution followed by oxygen plasma treatment at 100 W to 300 W for 1 to 5 minutes. The silane compound may be desirably 3-(trimethoxysilyl)propyl methacrylate (TMSPMA). The silane compound solution treatment may be performed at a temperature of 50°C to 80°C for 30 minutes to 2 hours.

In the preparing of the UV-curable polymer, a solution in which the UV-curable polymer and a photocuring agent may be applied onto the surface-treated wafer. The coating may include at least one selected from the group consisting of spray coating, spin coating, dip coating, screen coating, knife coating, kiss coating, gravure coating, bar coating, screen printing and spray-mist spray coating, and may be desirably spin coating.

The photomask may have circular patterns arranged in various shapes. The patterns may be aligned in any one of a grid, honeycomb, linear, and square arrangement, but are not limited thereto and may be arranged in various forms as needed. The photomask may be patterned by arranging patterns of a desired shape in which the conductive balls are finally arranged.

The UV-curable polymer is not limited to those listed above, and may be desirable to have low adhesiveness to the stretchable base material. The UV-curable polymer may be patterned by UV irradiation so that a portion exposed to the UV light is cured and a portion not exposed to the UV light is not cured.

According to an embodiment, in the performing of the patterning, the UV-curable polymer may be patterned into a cured hard gel and an uncured soft gel, the soft gel may form the concave portion, and the concave portion may have a depth that is 10% to 30% of a diameter of the conductive ball.

The portion of the UV-curable polymer that is exposed to the UV light may be cured to form a hard gel, while the portion thereof that is not exposed to the UV light may not be cured to form a soft gel. It may be cured into a desired pattern by a photomask, and the shape of the pattern may be concave. This may be due to a difference in a refractive index between the cured UV-curable polymer and the uncured UV-curable polymer. The concave pattern may have viscosity due to a viscoelastic polymer at an interface of the UV-curable polymer.

When the depth of the concave portion is less than 10% of the diameter of the conductive ball, the conductive balls may not be property arranged, and when the depth of the concave portion exceeds 30% thereof, the stretchable base material may cover the upper portion of the conductive ball when forming a film, and accordingly, the upper portion of the conductive ball may not be opened or a thickness of the film may not be appropriate. When the depth ratio of the concave portion is formed within the above range, the surface of the conductive ball may be appropriately exposed, thereby manufacturing a S-ACF with excellent stretchability and conductivity.

According to an embodiment, in the performing of the patterning, the UV light may be irradiated for 1 second to 10 seconds, a distance between the UV-curable polymer and a UV light source may be 8 cm to 16 cm, and the UV light may have intensity of 2 mW/cm² to 20 mW/cm².

A UV irradiation time may be desirably 1 second to 8 seconds; 1 second to 6 seconds; 1 second to 4 seconds; 1 second to 3 seconds; 3 seconds to 10 seconds; 3 seconds to 8 seconds; 3 seconds to 6 seconds; 3 seconds to 5 seconds; 4 seconds to 10 seconds; 4 seconds to 8 seconds; or 4 seconds to 6 seconds.

The distance between the UV-curable polymer and the UV light source may be desirably 8 cm to 14 cm; 8 cm to 12 cm; 8 cm to 10 cm; 10 cm to 16 cm; 10 cm to 14 cm; 10 cm to 12 cm; 12 cm to 16 cm; or 12 cm to 14 cm.

The UV intensity may be desirably 2 mW/cm² to 18 mW/cm²; 2 mW/cm² to 14 mW/cm²; 2 mW/cm² to 10 mW/cm²; 2 mW/cm² to 6 mW/cm²; 4 mW/cm² to 20 mW/cm²; 4 mW/cm² to 18 mW/cm²; 6 mW/cm² to 14 mW/cm²; 6 mW/cm² to 10 mW/cm²; 8 mW/cm² to 20 mW/cm²; 8 mW/cm² to 18 mW/cm²; 8 mW/cm² to 14 mW/cm²; or 8 mW/cm² to 10 mW/cm².

When UV is irradiated under the above conditions, the photoreaction of the UV-curable polymer may be smoothly performed, and the concave portion with a depth sufficient to smoothly adhere the conductive ball and to cause the surface of the conductive ball to be exposed to the stretchable base material may be clearly formed.

According to an embodiment, in the disposing of the conductive balls, the conductive balls may be rubbed on the mold, the conductive ball may be adhered to the concave portion, and the concave portion may have an adhesive force of 1 nN to 90 nN.

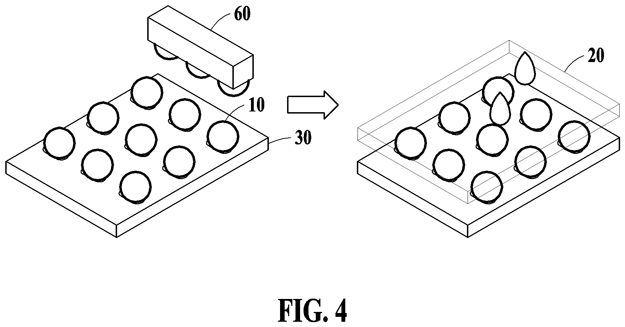

FIG. 4 is a schematic view of a step of disposing conductive balls and a step of applying a stretchable base material of a method of manufacturing a S-ACF according to an embodiment of the present disclosure. Referring to FIG. 4, the rubbing may be performed using an elastic member 60 to dispose the conductive balls 10 on the patterned mold 30, and the stretchable base material 20 may be applied onto the mold 30 in which the conductive balls 10 are disposed, thereby forming the S-ACF.

A concave pattern formed by the uncured UV-curable polymer may have an adhesive force due to the viscoelastic polymer at the interface of the UV-curable polymer. The rubbing may be a process of disposing the conductive balls on the concave portion with the adhesive force, and may be a process of coating the conductive balls with an elastic member stamp and rubbing the conductive balls against the patterned mold to arrange the conductive balls.

The elastic member may perform a function of holding the conductive balls, and more specifically, a function of directly contacting with the conductive balls to perform rubbing on the pattern of the concave portion formed in the mold. The elastic member may include at least one selected from the group consisting of polydimethylsiloxane (PDMS), polyurethane acrylate (PUA), polymethyl methacrylate (PMMA), polybutadiene (PB), PU, styrenebutadiene rubber (SBR), polyvinylidene fluoride (PVDF), poly(vinylidenefluorideco-trifluoroethylene) (PVDF-TrFE), PS, SBS (poly(ethylene glycol) diacrylate) (PEDGA), ploy(SBS), poly(SEBS), and poly(SIS). The elastic member may reciprocate a predetermined distance in one direction of the patterned mold one or multiple times, and accordingly, the elastic member may dispose the conductive balls on the concave portion of the patterned mold.

The conductive balls may be adhered by the adhesive force formed in the concave portion. The adhesive force may be desirably 1 nN to 70 nN; 1 nN to 50 nN; 1 nN to 30 nN; 1 nN to 10 nN; 10 nN to 90 nN; 10 nN to 70 nN; 10 nN to 50 nN; 10 nN to 30 nN; 30 nN to 90 nN; 30 nN to 70 nN; 30 nN to 50 nN; 50 nN to 90 nN; or 50 nN to 70 nN. When the adhesive force is less than 1 nN, the adhesive force may be weak, causing the conductive balls to not adhere and easily fly away, or the conductive balls may not be properly arranged, making it difficult to manufacture a high-assembly ACF. When the adhesive force exceeds 90 nN, the conductive malls may remain in the mold due to the conductive balls being inserted into the stretchable base material when peeling the stretchable base material off, rather than being transferred to the film.

According to an embodiment, the method may further include performing air blowing after the disposing of the conductive balls.

The mold in which the conductive balls are disposed may have conductive balls in a hard gel as well as in a soft gel with a concave pattern. The conductive balls not disposed on the pattern may be removed by performing the air blowing to remove the conductive balls not disposed on the pattern. The conductive balls formed in the concave portion may not fly away even when the air blowing is performed due to the adhesive force.

In the applying of the stretchable base material onto the mold in which the conductive balls are disposed, the stretchable base material may be applied by exposing the conductive balls. That is, the coating may be performed by adjusting the applied stretchable base material not to completely cover the conductive balls. The coating may include at least one selected from the group consisting of spray coating, spin coating, dip coating, screen coating, knife coating, kiss coating, gravure coating, bar coating, screen printing and spray-mist spray coating, and may be desirably spin coating.

The stretchable base material may be applied in a state of a solution diluted in a solvent. When a concentration of the solution is excessively high or a coating speed is excessively low, the conductive balls may be completely covered, and the surface of the conductive ball may not be exposed, making it difficult to form conductivity with a target member. When the concentration is excessively low or the coating speed is excessively high, the applied thickness of the stretchable base material may become too thin, preventing proper contact between the target member and the contact portion. Therefore, it is necessary to perform the coating by considering the concentration and the speed.

The solvent may be removed by heat treatment at a temperature of 50°C to 80°C for 1 to 10 minutes.

According to an embodiment, in the removing of the mold, the stretchable base material may be peeled off, and the conductive balls may be inserted and aligned in the stretchable base material.

The stretchable base material may be applied in a form in which the conductive balls are inserted and aligned in the stretchable base material, and the S-ACF may be manufactured by peeling the mold off.

In the process of the related art, it was difficult to manufacture a fine-pitch S-ACF while performing the hot press to apply the conductivity by exposing the conductive balls, and the conditions of a high temperature and high pressure was required. However, in the method of manufacturing a S-ACF according to the present disclosure, the method of manufacturing the patterned mold, disposing the conductive balls thereon, and applying the stretchable base material and peeling it off may be used, thereby manufacturing a S-ACF with a fine-pitch of 20 µm or less at a low temperature under low pressure.

Hereinafter, the present disclosure will be described in more detail with reference to examples.

However, the following examples are only for illustrating the present disclosure, and the present disclosure is not limited to the following examples.

### Examples

### Manufacturing of S-ACF

### (1) Chemical surface treatment of silicon wafer

To form a stable bond between a PEG-DA layer, which is the UV-curable polymer, and a silicon wafer, the silicon wafer was treated with TMSPMA. The silicon wafer was treated with oxygen plasma (200 W, 2 min) to form a hydroxyl group on a surface thereof, then immersed in a TMSPMA solution diluted in ethanol (3 wt% in EtOH) at 60°C for 1 hour, taken out, rinsed with ethanol, and dried with air blowing.

### (2) Formation of UV-curable polymer pattern

A solution (PEG-DA:HOMPP = 9: 1) in which the polymer main material, PEG-DA, and its photocuring agent, 2-hydroxy-2-methylpropiophenon (HOMPP) was spin-coated on the silicon wafer treated with TMSPMA (30 sec, 1000 rpm). Then, a photomask designed to match the pattern was placed thereon and UV curing was performed. The PEG-DA portion covered by a chrome pattern of the photomask may not be exposed to UV light and thus may not be cured, while a transparent portion may be exposed to UV light and may be cured. The PEG-DA pattern shape is concave rather than rectangular, which is caused by a difference in refractive index between the cured PEG-DA and the uncured PEG-DA. Then, the photomask was peeled off from the PEG-DA layer, and the PEG-DA in an uncured liquid form in the portion of the chrome pattern was washed away with toluene while spin coating (30 sec, 2000 rpm). Then, heat treatment (60°C, 5 min) was performed to remove the remaining toluene, and the formed concave pattern had an adhesive force due to a viscoelastic polymer at an interface of the uncured PEG-DA.

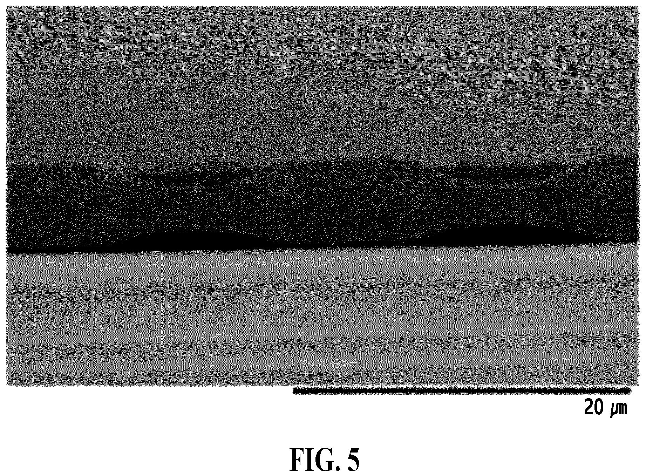

FIG. 5 is a scanning electron microscope (SEM) image of a patterned mold according to an embodiment of the present disclosure. Referring to FIG. 5, a cross-section of a patterned mold in which the uncured portion after UV irradiation has a concave shape may be seen, and a conductive ball may adhere to the concave pattern.

### (3) Arrangement of conductive balls and applying of stretchable base material

The conductive balls (20, 10, 5, 2.5 µm) according to the formed pattern were coated with the PDMS stamp, and rubbed against the PEG-DA layer with the concave pattern to arrange the conductive balls, and the conductive balls not on the pattern were removed by the air blowing. The adhesive force of the concave pattern prevents the conductive balls on the pattern from being blown away even in strong winds. Then, a SEBS-g-MA solution diluted in toluene of an appropriate concentration was spin-coated so as not to cover the entire portions of the conductive balls, and therefore, a film was formed only in the center of the conductive ball. The remaining toluene was removed by heat treatment (60°C, 5 minutes).

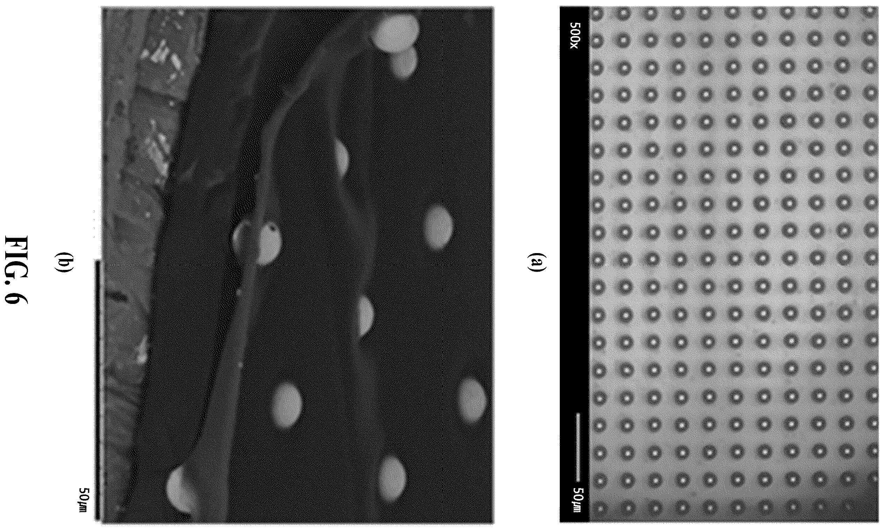

FIG. 6 is an optical microscope (OM) image (a) of a mold in which conductive balls are disposed and an SEM image (b) of a cross section of a S-ACF according to an embodiment of the present disclosure. Referring to (a) of FIG. 6, it may be confirmed that the conductive balls are well adhered to the mold in a predetermined pattern, and referring to (b) of FIG. 6, it may be confirmed that a S-ACF in which the conductive balls are inserted into the stretchable base material is manufactured.

### Experimental example

The S-ACF of the example was transferred between two electrode circuits and used as an electrical interface by hot press (0.1 MPa) at 80°C for 10 minutes. The electrode circuit was formed with five lines, 1 to 5. IV measurement was performed for performance testing.

For the electrode circuit, Au sputtering (20 mA, 300s DC magnetron sputter) was performed on a PET substrate using a metal mask to form the electrode circuit. After the hot press of the S-ACF of the example between the two electrode circuits, a liquid metal was lightly applied to an end of a lower electrode, a liquid metal was lightly applied to an end of an upper electrode, a conductive tape was attached, and then a liquid metal was lightly applied to the end again. Then, an IV tip was contacted at each end. For IV measurement conditions, 1 mA was set as compliance and a current value was measured by applying from 0 to 2 V.

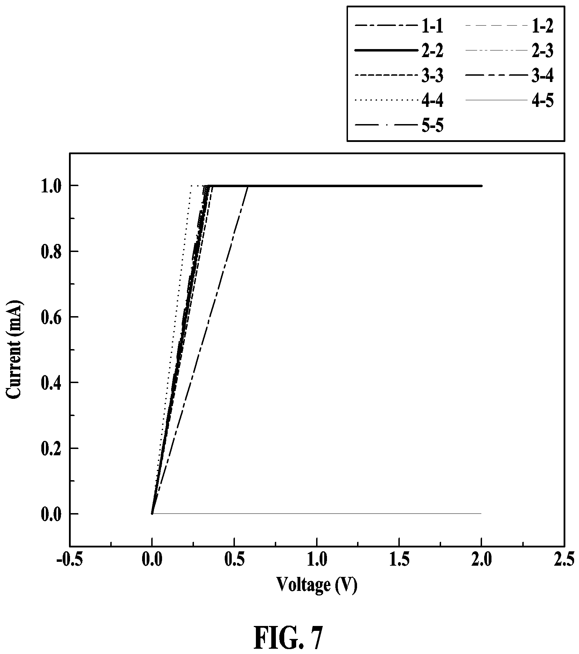

FIG. 7 is a graph showing a result of IV measurement of an electronic device to which a S-ACF is applied according to an embodiment of the present disclosure. Referring to FIG. 7, for the same line, such as 1-1, 2-2, 3-3, 4-4, and 5-5, an ohmic curve was observed, whereas when different lines were contacted and measured, it was confirmed that no current flowed.

While the embodiments are described, it will be apparent to one of ordinary skill in the art that various alterations and modifications in form and details may be made in these embodiments without departing from the spirit and scope of the claims and their equivalents. For example, suitable results may be achieved if the described techniques are performed in a different order, and/or if components in a described system, architecture, device, or circuit are combined in a different manner, or replaced or supplemented by other components or their equivalents.

Therefore, other implementations, other embodiments, and equivalents to the claims are also within the scope of the following claims.

## Claims

1. A stretchable anisotropic conductive film comprising:
a stretchable base material; and
conductive balls inserted and aligned within the stretchable base material.

2. The stretchable anisotropic conductive film of claim 1, wherein the stretchable base material comprises thermoplastic rubber grafted with maleic anhydride comprising at least one thermoplastic rubber selected from the group consisting of styrene-ethylene-butylene-styrene (SEBS), styrene-isoprene-styrene (SIS), styrene-butadiene-styrene (SBS), polyurethane (PU)-based rubber, and polyolefin (PO) rubber.

3. The stretchable anisotropic conductive film of claim 1, wherein
the conductive balls comprise particles of at least one selected from the group consisting of polystyrene (PS), PU, polyethylene (PE), polypropylene (PP), polybutylene (PB), nylon, and styrene-divinyl benzene, and
the particles are coated with at least one selected from the group consisting of gold (Au), nickel (Ni), silver (Ag), copper (Cu), aluminum (Al), palladium (Pd), chromium (Cr), titanium (Ti), tin (Sn), and molybdenum (Mo).

4. The stretchable anisotropic conductive film of claim 1, wherein
the conductive ball has a diameter of 1 micrometer (µm) to 100 µm,
spacing between the conductive balls is 1 µm to 100 µm,
a pitch is 2 µm to 200 µm, and
the diameter of the conductive ball and the spacing between the conductive balls have a ratio of 2:1 to 1:2.

5. The stretchable anisotropic conductive film of claim 1, wherein the stretchable base material has a thickness that is 40% to 70% of the diameter of the conductive ball.

6. The stretchable anisotropic conductive film of claim 1, wherein
the stretchable base material has uniform physical properties over the entire portion,
the conductive balls are inserted and aligned vertically in a surface of the stretchable anisotropic conductive film so that both surfaces of the stretchable anisotropic conductive film are electrically connected, and
the conductive ball has 30% to 60% of an outer surface exposed to outside of the stretchable base material.

7. A method of manufacturing a stretchable anisotropic conductive film, the method comprising:
manufacturing a mold patterned with a pattern comprising a concave portion;
disposing conductive balls in the mold;
applying a stretchable base material onto the mold in which the conductive balls are disposed; and
removing the mold.

8. The method of claim 7, wherein the manufacturing of the mold is performed by photolithography, nanoimprint, soft lithography, block copolymer lithography, or capillary lithography.

9. The method of claim 7, wherein the manufacturing of the mold comprises:
preparing a ultraviolet (UV)-curable polymer;
performing patterning by positioning a photomask on the UV-curable polymer and irradiating the photomask with UV light; and
obtaining a patterned mold by washing the patterned UV-curable polymer, and
the UV-curable polymer comprises at least one selected from the group consisting of polyethylene glycol diacrylate (PEG-DA), epoxy acrylate, polyester acrylate, polyurethane arylate, and silicone acrylate.

10. The method of claim 9, wherein
in the performing of the patterning, the UV-curable polymer is patterned into a cured hard gel and an uncured soft gel,
the soft gel forms the concave portion, and
the concave portion has a depth that is 10% to 30% of a diameter of the conductive ball.

11. The method of claim 9, wherein
in the performing of the patterning, the UV light is irradiated for 1 second to 10 seconds,
a distance between the UV-curable polymer and a UV light source is 8 cm to 16 cm, and
the UV light has intensity of 2 mW/cm² to 20 mW/cm².

12. The method of claim 7, wherein
in the disposing of the conductive balls, the conductive balls are rubbed on the mold,
the conductive ball is adhered to the concave portion, and
the concave portion has an adhesive force of 1 nN to 90 nN.

13. The method of claim 7, further comprising:
performing air blowing after the disposing of the conductive balls.

14. The method of claim 7, wherein
in the removing of the mold, the stretchable base material is peeled off, and
the conductive balls are inserted and aligned in the stretchable base material.
